(19) **Europäisches Patentamt / European Patent Office / Office européen des brevets**

(11) **EP 4 518 636 B1**

(12) **EUROPEAN PATENT SPECIFICATION**

(45) Date of publication and mention
of the grant of the patent:
**03.06.2026 Bulletin 2026/23**

(21) Application number: **24197707.3**

(22) Date of filing: **30.08.2024**

(51) International Patent Classification (IPC):
*H10N 30/077* (2023.01)   *H04R 17/02* (2006.01)
*H10N 30/092* (2023.01)   *H10N 30/85* (2023.01)
*H10N 30/30* (2023.01)   *H10N 30/853* (2023.01)

(52) Cooperative Patent Classification (CPC):
**H10N 30/852; H04R 17/02; H10N 30/077;
H10N 30/092;** H10N 30/306; H10N 30/8536

(54) **COMPOSITE MATERIAL WITH PIEZOELECTRIC PROPERTIES, PRODUCTION PROCESS THEREOF AND ELECTRONIC COMPONENT COMPRISING THE COMPOSITE MATERIAL**

VERBUNDWERKSTOFF MIT PIEZOELEKTRISCHEN EIGENSCHAFTEN, DESSEN HERSTELLUNGSVERFAHREN UND ELEKTRONISCHES BAUTEIL MIT DEM VERBUNDWERKSTOFF

MATÉRIAU COMPOSITE À PROPRIÉTÉS PIÉZOÉLECTRIQUES, SON PROCÉDÉ DE FABRICATION ET COMPOSANT ÉLECTRONIQUE COMPRENANT LE MATÉRIAU COMPOSITE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **01.09.2023 IT 202300018027**

(43) Date of publication of application:
**05.03.2025 Bulletin 2025/10**

(73) Proprietor: **STMicroelectronics International N.V.
1228 Plan-les-Ouates, Geneva (CH)**

(72) Inventors:
• **VERRENGIA CAPOROSSI, Christian
80014 GIUGLIANO IN CAMPANIA (NA) (IT)**
• **ESPOSITO, Annachiara
80136 NAPOLI (IT)**
• **BARBATO, Paola Sabrina
80078 POZZUOLI (NA) (IT)**
• **CASUSCELLI, Valeria
80128 NAPOLI (IT)**
• **SCALDAFERRI, Rossana
84079 VIBONATI (SA) (IT)**

(74) Representative: **Studio Torta S.p.A.
Via Viotti, 9
10121 Torino (IT)**

(56) References cited:
EP-A1- 4 074 672      CN-A- 115 028 864
US-A1- 2011 037 015

• **DASH S ET AL: "Enhancing functional properties of PVDF-HFP/BZT-BCT polymer-ceramic composites by surface hydroxylation of ceramic fillers", CERAMICS INTERNATIONAL, ELSEVIER, AMSTERDAM, NL, vol. 47, no. 23, 23 August 2021 (2021-08-23), pages 33563 - 33576, XP086830685, ISSN: 0272-8842, [retrieved on 20210823], DOI: 10.1016/J.CERAMINT.2021.08.265**
• **BARBATO P ET AL: "Green Synthesis of Piezoelectric Thin Films based on Niobium Doped Barium Zirconate Titanate - Barium Calcium Titanate (Nb-BZT-BCT)", vol. 101, 30 July 2023 (2023-07-30), IT, pages 73 - 78, XP093136020, ISSN: 2283-9216, Retrieved from the Internet <URL:https://www.cetjournal.it/cet/23/101/013.pdf> DOI: 10.3303/CET23101013**
• **XU C ET AL: "Enhanced piezoelectric properties and thermal stability in tetragonal-structured (Ba,Ca)( Zr,Ti)O3 piezoelectrics substituted with trace amount of Mn", CERAMICS INTERNATIONAL, ELSEVIER, AMSTERDAM, NL, vol. 42, no. 14, 19 July 2016 (2016-07-19), pages 16109 - 16115, XP029686958, ISSN: 0272-8842, DOI: 10.1016/J.CERAMINT.2016.07.125**

EP 4 518 636 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

- SHAIK H ET AL: "Towards [beta]-phase formation probability in spin coated PVDF thin films", JOURNAL OF POLYMER RESEARCH, SPRINGER NETHERLANDS, DORDRECHT, vol. 24, no. 3, 9 February 2017 (2017-02-09), pages 1 - 6, XP036205348, ISSN: 1022-9760, [retrieved on 20170209], DOI: 10.1007/S10965-017-1191-X
- SARKAR L ET AL: "Preparation and optimization of PVDF thin films for miniaturized sensor and actuator applications", SMART MATERIALS AND STRUCTURES, IOP PUBLISHING LTD., BRISTOL, GB, vol. 30, no. 7, 28 May 2021 (2021-05-28), pages 75013, XP020367162, ISSN: 0964-1726, [retrieved on 20210528], DOI: 10.1088/1361-665X/ABFF15

**Description**

<u>Technical field</u>

The present invention relates to a composite material with piezoelectric properties, to a process for producing a thin film comprising the composite material and to the electronic component comprising the composite material. The electronic component may be for example a microelectromechanical (MEMS) device such as an acoustic sensor or actuator, in particular a microphone.

<u>Background</u>

Significant progress has recently been made in the development of innovative materials for piezoelectric and acoustoelectric conversion. Acoustoelectric conversion has numerous applications, for example, for sound detection and recording, speed measurement, human activity detection, entertainment, information recognition, elderly care and security.

Acoustoelectric conversion may also be used for small-scale energy harvesting and powering. In fact, acoustoelectric conversion converts acoustic waves into electrical signals and may be obtained by exploiting several phenomena such as, for example, the piezoelectric effect.

Piezoelectric acoustoelectric conversion, based on the deformation of a material caused by the vibrations of acoustic waves, is particularly suitable for developing flexible devices.

Conventionally, piezoelectric films are used to manufacture acoustoelectric transducers. In this context, recently, piezoelectric polymers have aroused particular interest, such as, for example, polyvinylidene fluoride (PVDF) and its copolymers, or composites based on a piezoelectric polymeric matrix that have shown acoustoelectric transduction capabilities.

These materials are particularly advantageous as, compared to piezoelectric ceramics, they have excellent flexibility.

It is generally recognized that PVDF, as a semicrystalline polymer, has five polymorphs: $\alpha$, $\beta$, $\gamma$, $\delta$ and $\epsilon$. The piezoelectric property of PVDF is attributed to the existence of polar crystalline phases, including the $\beta$- and $\gamma$-phase, and the $\beta$-phase shows the greatest electric dipole moment among all crystalline phases of the polymer. Therefore, one of the strategies to improve the piezoelectric performances of PVDF-based sensors, actuators and energy harvesting transducers has been that of increasing the $\beta$-phase content.

Although the piezoelectric coefficient of PVDF and its copolymers is not as high as that of inorganic piezoelectric materials, their good flexibility, strength, chemical resistance, and biocompatibility make them promising piezoelectric candidates for self-powered sensors, microphones, and energy harvesting transducers.

PVDF-based composites containing piezoelectric ceramic fibers have also been prepared over the years in order to optimize PVDF-based devices and to obtain higher sensitivity and higher output power, thus laying the foundation for various applications, for example, in the wearable devices and implants sectors.

On the other hand, the materials currently available (for example aluminum nitride, AlN) have a long and complex production process, which may envisage over thirty deposition steps to form layers of useful thickness in commercial applications.

New piezoelectric materials with improved performances and easy production are therefore being sought.

Therefore, the aim of the present invention is to provide a new material with improved piezoelectric and ferroelectric properties which overcomes the drawbacks of the prior art and in particular which allows easier manufacturing of devices incorporating it. Examples of prior art documents are CN115028864A and DASH S ET AL: "Enhancing functional properties of PVDF-HFP/BZT-BCT polymer-ceramic composites by surface hydroxylation of ceramic fillers", CERAMICS INTERNATIONAL, vol. 47, no. 23, 23 August 2021, pages 33563-33576.

<u>Summary</u>

This aim is achieved thanks to a composite material, a method for producing a thin film and the electronic component thus obtained according to the attached claims.

<u>Brief Description of the Drawings</u>

For a better understanding of the present invention, some embodiments thereof are now described, purely by way of non-limiting example, with reference to the attached drawings, wherein:

- Figure 1 illustrates the X-ray diffraction (XRD) spectrum of the composite sample comprising PVDF and 25% of 2%BCNZT, i.e. $(1-\alpha)$ Ba $(Zr_{(0.2-0.5y)}$ Ti $_{(0.8-0.5y)})$ Nb$_y$O$_3$-$\alpha$Ba$_{0.7}$Ca$_{0.3}$(Ti$_{(1-y)}$Nb$_y$)O$_3$, where $\alpha$ indicates the ratio between BZT and BCT and y=0.02 indicates the degree of substitution of Nb with respect to the sum of Ti and Zr;

- Figure 2 illustrates a cross-section through a portion of a generic MEMS device having a piezoelectric actuation structure;

- Figure 3 illustrates the results of the ferroelectric analysis conducted on a thin film made of PVDF and on a thin film formed with an undoped PVDF and BZT-BCT composite;

- Figure 4 illustrates the results of the ferroelectric analysis conducted on a thin film formed with a PVDF and 2%BCNZT composite present in quantities of 15%, 20% and 25% on the total weight of the composite;

- Figure 5 illustrates the plot of the capacitance C as a function of the frequency f in a composite material layer formed according to the present disclosure;

- Figure 6 illustrates the plot of the inductance Lp as a function of the frequency f in a composite material layer formed according to the present disclosure, for different percentages of dispersed phase load;

- Figure 7 illustrates the plot of the phase $\Phi$ as a function of the frequency f in a composite material layer formed according to the present disclosure, for different percentages of dispersed phase load;

- Figure 8 illustrates the displacement s as a function of the frequency f in a composite material layer formed according to the present disclosure;

- Figure 9 illustrates the plot of the amplitude A as a function of the frequency f in a composite material layer formed according to the present disclosure and used respectively in an ultrasonic detector (A_DUT) and in an ultrasonic microphone (A_MIC); and

- Figure 10 shows an example of device 20 using the present composite material.

<u>Description of Embodiments</u>

The present description relates to a composite material comprising a fluoropolymer matrix and a filler formed by nanoparticles of a ceramic of the BZT-$\alpha$BXT type wherein X is selected from Ca, Sn and Mn and $\alpha$ is a molar fraction selected in the range between 0.10-0.90 doped with at least one doping element selected from the group consisting of Nb, La, Mn, Nd and W, provided that when X is Mn, the doping element is not Mn. The nanoparticles have an average diameter comprised between 100 and 200 nm.

Advantageously, the present composite material has shown improved ferroelectric and piezoelectric properties and inductive behavior.

In particular, the presence of nanoparticles favors an exchange at the matrix-nanoparticle interface. Unlike the use of fibers, which favor the stiffening of the thin film, nanoparticles allow the conductive paths essential for the inductive properties and a flexible thin film to be obtained.

In particular, the size range 100-200 nm maximizes the interface between polymer and filler. Average nanoparticle diameters greater than 200 nm do not guarantee an effective interface between the polymer and the ceramic for charge transfer. Instead, nanoparticles with an average diameter of less than 100 nm tend to coalescence, impeding a homogeneous distribution in the material.

The doping elements La, Mn and Nd can replace the element in position A (barium and calcium site) while Nb and W can replace the element in position B (titanium and zirconium site).

In one embodiment, the fluoropolymer is selected from the group consisting of polyvinylidene fluoride (PVDF) and its copolymers, in particular, copolymers of PVDF with hexafluoropropylene (HFP) or with trifluoroethylene (TrFE).

In particular, PVDF and its copolymers may have a beta-phase percentage mass fraction, with respect to the sum of the masses of the crystalline phases, of at least 70%, more particularly between 86% and 99%.

The ceramic of the BZT-$\alpha$BXT type may be a ceramic of the Barium Zirconate Titanate-Barium Calcium Titanate (BZT-BCT) type, in particular a ceramic of the 1-$\alpha$)Ba(Zr$_{(0.2-0.5y)}$Ti$_{(0.8-0.5y)}$)Nb$_y$O$_3$-$\alpha$Ba$_{0.7}$Ca$_{0.3}$(Ti$_{(1-y)}$Nb$_y$)O$_3$ type, where $\alpha$ indicates the ratio between BZT and BCT and y=0.01-5% by weight on the total weight of the ceramic indicates the degree of substitution of Nb with respect to the sum of Ti and Zr, in particular y=2% by weight on the total weight of the ceramic.

The composite material has a ceramic (filler) content comprised between 10% and 25% by weight on the total weight of the composite, in particular 20%.

Outside this range the properties begin to decay to a complete loss of inductive behavior. Filler percentages greater than 25% lead to an onset of coalescence phenomena, the frequency of which increases as the filler percentage increases; such coalescence phenomena lead to an increased possibility of electrical short circuits. In contrast, a filler percentage of less than 10% results in an uneven distribution of filler within the matrix.

Hereinbelow there is described an embodiment of a process for producing a thin film formed with the composite material described above. In detail, the process comprises:

a) submitting a dispersion of ceramic nanoparticles in an organic fluoropolymer solution to a first spin-coating step at a speed comprised between 500 and 1500 rpm, to a second spin-coating step at a speed comprised between 3500 and 5500 rpm; and to a third spin-coating step at a speed comprised between 8500 and 12000 rpm;
b) submitting the product of step a) to a first annealing step at a temperature comprised between 60 and 70°C and to a second annealing step at a temperature comprised between 80 and 90°C.

Advantageously, this method allows a homogeneous and uniform thin film to be formed.

In particular, the first spin-coating step, conducted for example at 1000 rpm, leads to the application of the composite material on the entire surface of the substrate; the second spin-coating step, conducted for example at 4000 rpm, favors a first evaporation of the solvent and the third spin-coating step, conducted for example at 9000 rpm, favors the formation of the beta phase as it allows the complete stretching of the PVDF chains and the rotation of the groups H and F.

Furthermore, the first annealing step favors a slow evaporation of the solvent which makes the surface of the thin film uniform and homogeneous; the second annealing step allows the polymer chains to consolidate after the total evaporation of the solvent.

Thanks to its ferroelectric and piezoelectric properties, the composite material may be used for manufacturing electronic components such as acoustic sensors, in particular microphones, energy harvesting transducers and micro-actuators.

Further characteristics will emerge from the following description of some merely illustrative and non-limiting examples.

## EXAMPLE 1. Preparation of the composite according to the present disclosure

- Preparation of 100 ml of 15% weight solution of PVDF

17.78 g of PVDF powder are dissolved in a solution of 70 ml of DMSO and 30 ml of Acetone. The solution is placed on a magnetic plate and stirred by magnetic stirring at a temperature of 100°C.

- Preparation of nanoparticles of BCT-BZT doped with 2% of Nb (2%BCNZT)

The BCNZT ceramic is prepared by Sol-Gel technique as described in EP 4074672. The precursor solution is then dried at 150°C and the powders are recovered.

Once recovered, the powders are homogenized and dry ground using a planetary ball mill at a speed of 400 rpm for 4 hours. They are subsequently calcined at 1400°C and wet regrinded for 8 hours with ethanol (1 ml) to obtain nanoparticles of the order of 100-200nm.

- Preparation of the composite

The 2%BCNZT nanoparticles are added in different amounts (15%, 20% 25% by weight on the composite weight) to the PVDF solution and are dispersed by ultrasonication and stirring. The solution is left on a plate for approximately 10 days to reach stability.

Once stabilized, the solution is deposited by spin-coating on a substrate to form a thin film. Three spin-coating steps are performed:
The method used envisages three steps:

- 1000 rpm per 10 s;
- 4000 rpm per 30 s;
- 9000 rpm per 60 s.

Subsequently the sample is placed for 10 min on a plate at 70°C for a first initial evaporation and subsequently on a plate at 90°C for another 10 min for the annealing step, finally it is cooled to room temperature T.

The films have been submitted to X-ray diffraction studies to verify the formation of the PVDF phases.

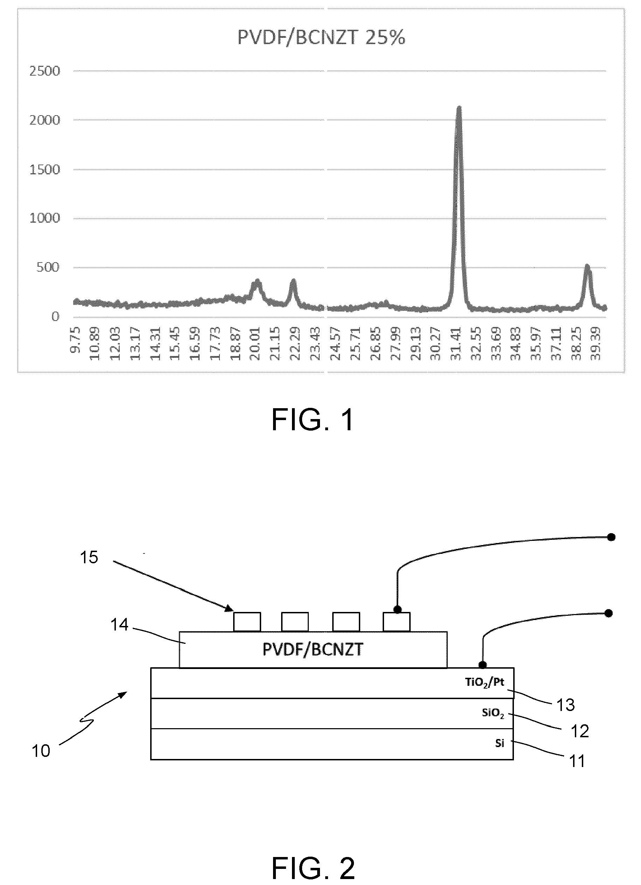

Figure 1 shows the X-ray diffraction (XRD) spectrum of the composite sample comprising 25% of 2%BCNZT; from this it is clear that only the $\beta$-phase is present in the PVDF. The intensity of the 2%BCNZT peak also demonstrates a high homogeneity of the composite analyzed.

## EXAMPLE 2. Electrical Characterization

For the electrical characterization, a sample 10 has been provided as shown in Figure 2.

The sample 10 comprises a semiconductor layer 11, for example of monocrystalline silicon; an insulating layer 12, for example of silicon oxide; a lower electrode layer 13, formed by a $TiO_2$/Pt multilayer; a composite layer 14 of the present PVDF-BCNZT composite material; and a plurality of upper electrodes 15 of Pt.

In the used sample, the stack of layers 11-13 has a total thickness of 700 μm; the composite layer 14 has a thickness of 2 μm and the upper electrodes 15 have a thickness of 120 nm.

The sample is sprayed (Turbo-Pumped Thermal Evaporator K975X) with platinum to form the upper electrodes and etched at the end to contact the lower electrode. Alternatively, a sputtering process may also be used to form the upper electrodes.

For all measurements, the electrodes were contacted with metal tips through manipulators on a hand-held spindle probe. Electrical property tests and impedance spectroscopy were performed with the Keysight B1500A semiconductor device analyzer. The ferroelectric properties were studied with the Aixact TFA TF2000E analyzer, applying a 30V, 5kHz triangular wave signal to the sample.

In particular, the samples tested are films formed with:

- PVDF polymer only;
- Composite comprising PVDF and BCT-BZT;
- Composite comprising PVDF and 15% of 2%BCNZT;
- Composite comprising PVDF and 20% of 2%BCNZT;
- Composite comprising PVDF and 25% of 2%BCNZT.

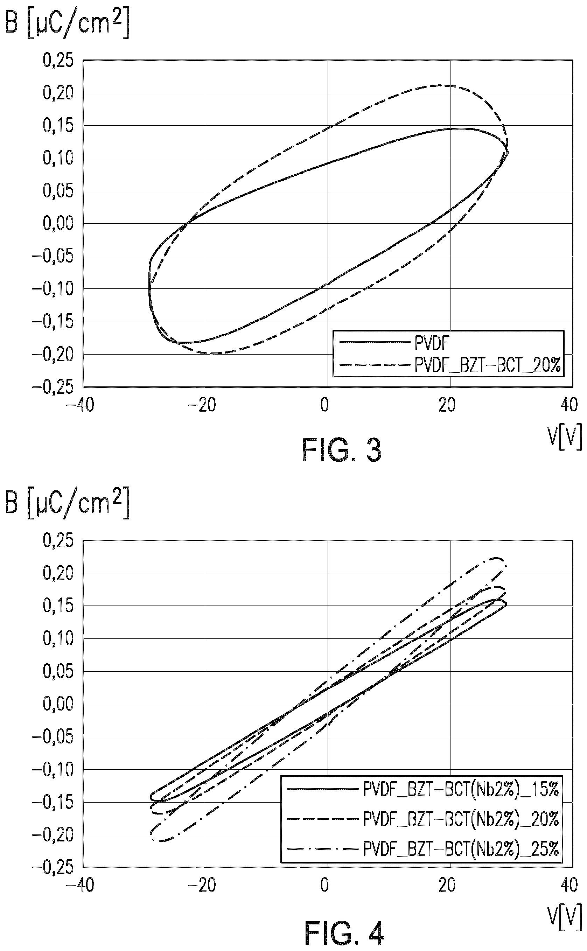

The results of the ferroelectric tests are shown in Figures 3 and 4.

PVDF and PVDF-BZTBCT thin films show broader ferroelectric properties associated with inductive behavior, likely due to conductive paths emerging in the PVDF matrix.

The shape of the ferroelectric curves of Figure 4 allows highlighting that the presence of Nb reduces the percolation path in the film which has a narrower characteristic with the same voltage.

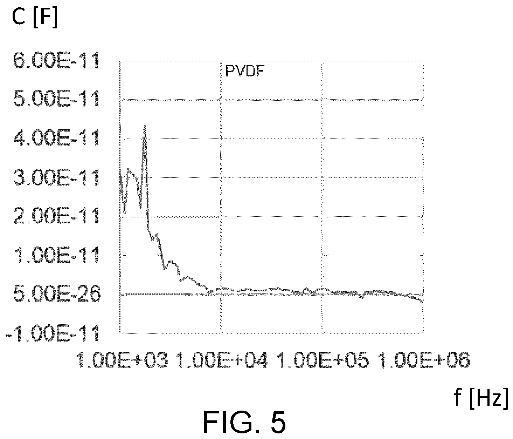

Interesting properties of Nb-doped composites emerged thanks to impedance measurements. The samples were tested with the B1530 module of the B1500A, applying a 50mV AC signal and no DC polarization to the samples. With this module frequencies from 1kHz to 5MHz may be tested. These measurements confirmed the dielectric properties of the PVDF as shown in Figure 5.

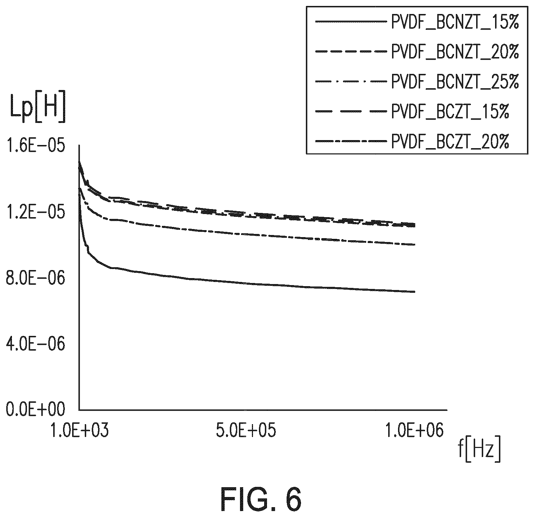

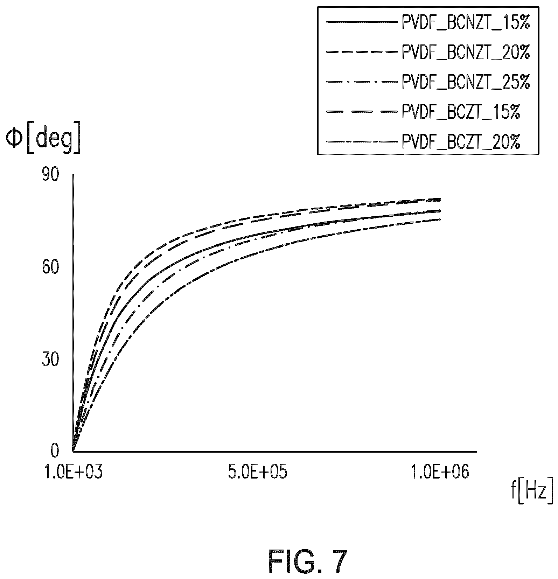

The described composites also showed an inductive nature measuring impedance and phase, as shown in Figures 6 and 7.

Finally, the piezoelectric properties were measured by a laser vibrometer (Polytec) on a cantilever-shaped device.

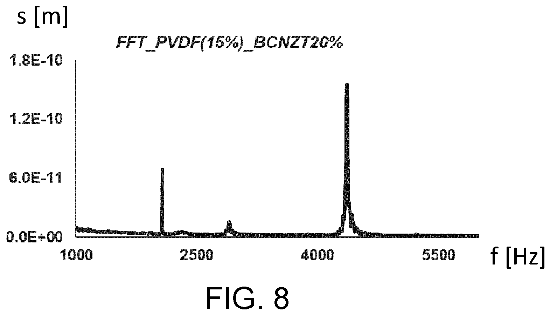

Films with different doping percentages were submitted to vibrometric testing using the MSA-500 Micro System Analyzer (Polytec) to estimate the piezoelectric parameters. In particular, the device was submitted to an acoustic wave generated by a loudspeaker controlled by an external sinusoidal signal (periodic chirp of 3 V) and the displacement was measured using a laser vibrometer. This allowed the resonance frequency to be extracted. Figure 8 shows the plot of the displacement as a function of the frequency presented by a device having a layer of the composite material containing PVDF and 20% of 2%BCNZT.

Once the resonance frequency was extracted, by setting voltage and frequency in proximity to the resonance, the deflection of the cantilever was estimated. The displacement and the corresponding value of the effective in-plane transverse piezoelectric coefficient e31f were shown in Table 1 according to the formula proposed by Mazzalai:

$$e_{31,f} = \frac{1}{3V} \frac{Y(t_{Si})^2}{3V(1-v)c_f} \frac{w(x_2)}{[2x_2 - x_1]x_1}$$

where Y is the Young's modulus, $v$ is the Poisson's ratio, $t_{Si}$ is the thickness of the substrate (in the sample of Figure 2, the semiconductor layer 11-13), $c_f$ is the coverage factor of the electrodes, $x_2$ is the length of the piezoelectric active area, $x_1$ is the length of the laser impingement point, $w(x_2)$ is the deflection, V is the amplitude of the sinusoidal signal applied.

Table 1

| Content [%] | | | Displacement | Piezoelectric Coefficient |
|---|---|---|---|---|
| PVDF | BZTBCT | Nb | $w(x_2)$ [m] | $e_{31,f}$ [C/m2] |
| 15 | 15 | 0 | 2.00 e-9 | 0.672 |
| 15 | 20 | 0 | 3.30 e-9 | 1.109 |
| 15 | 15 | 2 | 4.25 e-9 | 1.785 |

(continued)

| Content [%] | | | Displacement | Piezoelectric Coefficient |
|---|---|---|---|---|
| PVDF | BZTBCT | Nb | $w(x_2)$ [m] | $e_{31,f}$ [C/m2] |
| 15 | 20 | 2 | 9.00 e-9 | 3.781 |
| 15 | 25 | 2 | 2.70 e-9 | 1.134 |

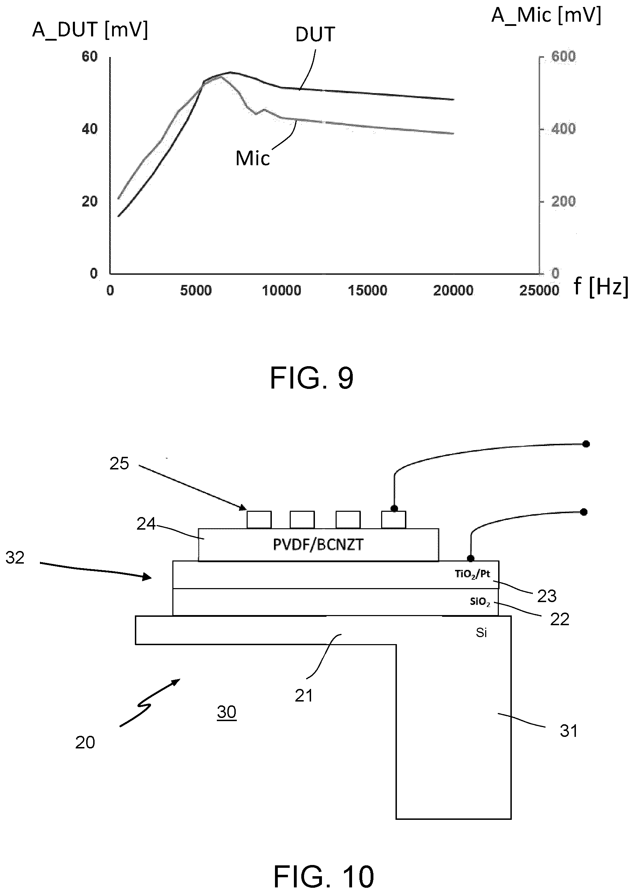

Furthermore, since a resonance frequency close to 4 kHz was detected, the behavior of various devices exposed to sound pressure was studied. The acoustic wave is sent from a speaker to the cantilever and with the Micro System Analyzer MSA-500 the response of a device comprising the described composite material of a certified commercial microphone was studied. The measurement was carried out by driving the speaker with a sinusoidal signal at various frequencies of the audible range, from 20Hz to 20 kHz. It has been found that the response of the device comprising the composite material comprising PVDF and 20% of 2%BCNZT follows the signal detected by the microphone, with an amplitude that differs by one tenth from the certified microphone, as shown in Figure 9, wherein A_Mic refers to the amplitude measured in the certified commercial microphone and A_DUT refers to the cantilever device using the present composite material.

Figure 10 shows an example of device 20 using the present composite material.

The device 20 is for example a MEMS sensor or actuator; in particular a microphone.

The device 20 has a suspended structure 21, here a cantilever, suspended over a cavity 30.

The cavity 30 is formed in a substrate 31 and delimits the suspended structure 21 at the bottom. The suspended structure 21 may be monolithic with the substrate 31. The suspended structure 21 and the fixed structure 31 are for example of monocrystalline silicon.

An insulating layer 22, for example of silicon dioxide, extends above the suspended structure 21 and an actuation or detection structure 32 extends on the insulating layer 22.

The actuation or detection structure 32 comprises a lower electrode layer 23, for example formed by a $TiO_2$/Pt multilayer; a composite layer 24, of the present PVDF_2% BCNZT composite material; and a plurality of upper electrodes 25, for example of Pt.

Finally, it is clear that modifications and variations may be made to the composite material and the production process described and illustrated herein, without departing from the scope of the present invention, as defined in the attached claims.

**Claims**

1. A composite material comprising a fluoropolymer matrix and a filler consisting of nanoparticles of a ceramic of the BZT-$\alpha$BXT type wherein X is selected from Ca, Sn and Mn and $\alpha$ is a molar fraction selected in the range between 0.10-0.90 doped with at least one doping element selected from the group consisting of Nb, La, Mn, Nd and W, provided that when X is Mn, the doping element is not Mn, wherein said nanoparticles have an average diameter comprised between 100 and 200 nm and wherein the filler is present in an amount comprised between 10% and 25% by weight of the total weight of the composite material.

2. The composite material according to claim 1, wherein the fluoropolymer matrix is selected from the group consisting of polyvinylidene fluoride, PVDF, and its copolymers.

3. The composite material according to claim 2, wherein the copolymers are selected from the group consisting of copolymers of PVDF with hexafluoropropylene, or copolymers of PVDF with trifluoroethylene, TrFE.

4. The composite material according to claim 2, wherein the fluoride, PVDF, polyvinylidene and its copolymers have a beta-phase percentage mass fraction, with respect to the sum of the masses of the crystalline phases, of at least 70%.

5. The composite material according to claim 1, wherein the doping element is present in an amount comprised between 0.01% and 5% by weight of the total weight of the ceramic.

6. The composite material according to claim 1, having a ceramic content of 20% by weight of the total weight of the composite material.

7. A process for producing a thin film comprising the composite material according to any of claims 1 to 6, comprising the steps of:

a) submitting a dispersion of nanoparticles in an organic-phase fluoropolymer solution to a first spin-coating step at a speed comprised between 500 and 1500 rpm; to a second spin-coating step at a speed comprised between 3500 and 5500 rpm; and to a third spin-coating step at a speed comprised between 8500 and 12000 rpm;
b) submitting the product of step a) to a first annealing step at a temperature comprised between 60 and 70°C and to a second annealing step at a temperature comprised between 80 and 90°C; wherein the nanoparticles are nanoparticles of a ceramic of the BZT-$\alpha$BXT type wherein X is selected from Ca, Sn and Mn and $\alpha$ is a molar fraction selected in the range between 0.10-0.90 doped with at least one doping element selected from the group consisting of Nb, La, Mn, Nd and W, provided that when X is Mn, the doping element is not Mn, wherein said nanoparticles have an average diameter comprised between 100 and 200 nm and wherein the filler is present in an amount comprised between 10% and 25% by weight of the total weight of the composite material.

8. An electronic component comprising a piezoelectric layer including the composite material according to any of claims 1-6.

9. The electronic component according to the preceding claim, forming an acoustic sensor.

10. The electronic component according to the preceding claim, wherein the acoustic sensor is a microphone.

**Patentansprüche**

1. Verbundmaterial, das eine Fluorpolymermatrix und einen Füllstoff umfasst, der aus Nanopartikeln einer Keramik des Typs BZT-$\alpha$BXT besteht, wobei X aus Ca, Sn und Mn ausgewählt ist und $\alpha$ ein Molanteil ist, der im Bereich zwischen 0,10 und 0,90 ausgewählt ist und mit mindestens einem Dotierungselement dotiert ist, das aus der Gruppe ausgewählt ist, die aus Nb, La, Mn, Nd und W besteht, vorausgesetzt, dass, wenn X Mn ist, das Dotierungselement nicht Mn ist, wobei die Nanopartikel einen durchschnittlichen Durchmesser zwischen 100 und 200 nm aufweisen und wobei der Füllstoff in einer Menge vorhanden ist, die zwischen 10 Gew.-% und 25 Gew.-% des Gesamtgewichts des Verbundmaterials beträgt.

2. Verbundmaterial nach Anspruch 1, wobei die Fluorpolymermatrix aus der Gruppe ausgewählt ist, die aus Polyvinylidenfluorid, PVDF, und ihren Copolymeren besteht.

3. Verbundmaterial nach Anspruch 2, wobei die Copolymere aus der Gruppe ausgewählt sind, die aus Copolymeren von PVDF mit Hexafluorpropylen, HFP, oder Copolymeren von PVDF mit Trifluorethylen, TrFE, besteht.

4. Verbundmaterial nach Anspruch 2, wobei das Polyvinylidenfluorid, PVDF, und dessen Copolymere einen Betaphasen-Prozentmassenanteil, bezogen auf die Summe der Massen der kristallinen Phasen, von mindestens 70 % aufweisen.

5. Verbundmaterial nach Anspruch 1, wobei das Dotierungselement in einer Menge vorhanden ist, die zwischen 0,01 Gew.-% und 5 Gew.-% des Gesamtgewichts der Keramik beträgt.

6. Verbundmaterial nach Anspruch 1, das einen Keramikgehalt von 20 Gew.-% des Gesamtgewichts des Verbundmaterials aufweist.

7. Verfahren zur Herstellung einer dünnen Schicht, die das Verbundmaterial nach einem der Ansprüche 1 bis 6 umfasst, umfassend die folgenden Schritte:

a) Unterziehen einer Dispersion von Nanopartikeln in einer Fluorpolymerlösung in organischer Phase einem ersten Schleuderbeschichtungsschritt mit einer Drehzahl zwischen 500 und 1500 U/min; einem zweiten Schleuderbeschichtungsschritt mit einer Drehzahl zwischen 3500 und 5500 U/min; und einem dritten Schleuderbeschichtungsschritt mit einer Drehzahl zwischen 8500 und 12000 U/min;
b) Unterziehen des Produkts von Schritt a) einem ersten Glühschritt bei einer Temperatur zwischen 60 und 70 °C und einem zweiten Glühschritt bei einer Temperatur zwischen 80 und 90 °C; wobei die Nanopartikel Nanopartikel einer Keramik des Typs BZT-$\alpha$BXT sind, wobei X aus Ca, Sn und Mn ausgewählt ist und $\alpha$ ein Molanteil ist, der im Bereich zwischen 0,10 und 0,90 ausgewählt ist und mit mindestens einem Dotierungselement dotiert ist, das aus der Gruppe ausgewählt ist, die aus Nb, La, Mn, Nd und W besteht, vorausgesetzt, dass, wenn X Mn ist, das Dotierungselement nicht Mn ist, wobei die Nanopartikel einen durchschnittlichen Durchmesser zwischen 100 und 200 nm aufweisen und wobei der Füllstoff in einer Menge vorhanden ist, die zwischen 10 Gew.-% und 25 Gew.-% des Gesamtgewichts des Verbundmaterials beträgt.

8. Elektronische Komponente, die eine piezoelektrische Schicht umfasst, einschließlich des Verbundmaterials nach einem der Ansprüche 1 bis 6.

9. Elektronische Komponente nach dem vorhergehenden Anspruch, die einen akustischen Sensor bildet.

10. Elektronische Komponente nach dem vorhergehenden Anspruch, wobei der akustische Sensor ein Mikrofon ist.

**Revendications**

1. Matériau composite comprenant une matrice fluoropolymère et une charge consistant en nanoparticules d'une céramique du type BZT-$\alpha$BXT dans lequel X est sélectionné parmi Ca, Sn, et Mn et $\alpha$ est une fraction molaire sélectionnée dans la plage entre 0,10-0,90 dopée avec au moins un élément dopant sélectionné dans le groupe consistant en Nb, La, Mn, Nd et W, pourvu que quand X est du Mn, l'élément dopant ne soit pas du Mn, dans lequel lesdites nanoparticules ont un diamètre moyen compris entre 100 et 200 nm et dans lequel la charge est présente dans une quantité comprise entre 10% et 25% en poids du poids total du matériau composite.

2. Matériau composite selon la revendication 1, dans lequel la matrice fluoropolymère est sélectionnée dans le groupe consistant en du polyfluorure de vinylidène, PVDF, et ses copolymères.

3. Matériau composite selon la revendication 2, dans lequel les copolymères sont sélectionnés dans le groupe consistant en des copolymères de PVDF avec de l'hexafluoropropylène, HFP, ou des copolymères de PVDF avec du trifluoroéthylène, TrFE.

4. Matériau composite selon la revendication 2, dans lequel le polyfluorure de vinylidène, PVDF, et ses copolymères ont une fraction de masse en pourcentage de phase béta, par rapport à la somme des masses des phases cristallines, d'au moins 70%.

5. Matériau composite selon la revendication 1, dans lequel l'élément dopant est présent dans une quantité comprise entre 0,01% et 5% en poids du poids total de la céramique.

6. Matériau composite selon la revendication 1, ayant un contenu en céramique de 20% en poids du poids total du matériau composite.

7. Processus de production d'un film fin comprenant le matériau composite selon l'une quelconque des revendications 1 à 6, comprenant les étapes de :

a) soumettre une dispersion de nanoparticules dans une solution de fluoropolymère en phase organique à une première étape de revêtement par centrifugation à une vitesse comprise entre 500 et 1500 tr-min ; à une seconde étape de revêtement par centrifugation à une vitesse comprise entre 3500 et 5500 tr-min ; et à une troisième étape de revêtement par centrifugation à une vitesse comprise entre 8500 et 12000 tr-min ;
b) soumettre le produit de l'étape a) à une première étape de recuit à une température comprise entre 60 et 70°C et à une seconde étape de recuit à une température comprise entre 80 et 90°C ; dans lequel les nanoparticules sont des nanoparticules d'une céramique du type BZT-$\alpha$BXT dans lequel X est sélectionné parmi Ca, Sn, et Mn et a est une faction molaire sélectionnée dans la plage entre 0,10-0,90 dopée avec au moins un élément dopant sélectionné dans le groupe consistant en Nb, La, Mn, Nd et W, pourvu que quand X est du Mn, l'élément dopant ne soit pas du Mn, dans lequel lesdites nanoparticules ont un diamètre moyen compris entre 100 et 200 nm et dans lequel la charge est présente dans une quantité comprise entre 10% et 25% en poids du poids total du matériau composite.

8. Composant électronique comprenant une couche piézoélectrique incluant le matériau composite selon l'une quelconque des revendications 1-6.

9. Composant électronique selon la revendication précédente, formant un capteur acoustique.

10. Composant électronique selon la revendication précédente, dans lequel le capteur acoustique est un microphone.

FIG. 1

FIG. 2

B [µC/cm²]

FIG. 3

B [µC/cm²]

FIG. 4

FIG. 5

FIG. 6

FIG. 7

FIG. 8

FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 115028864 A

- EP 4074672 A

**Non-patent literature cited in the description**

- **DASH S et al.** Enhancing functional properties of PVDF-HFP/BZT-BCT polymer-ceramic composites by surface hydroxylation of ceramic fillers. *CERAMICS INTERNATIONAL*, 23 August 2021, vol. 47 (23), 33563-33576